# EUROPÄISCHE PATENTSCHRIFT

(11) **EP 1 970 474 B1**
(45) Veröffentlichungstag und Bekanntmachung des Hinweises auf die Patenterteilung: **30.06.2010**
(21) Anmeldenummer: 08003282.4
(22) Anmeldetag: 22.02.2008
(51) Int. Cl.: C30B 23/06, C23C 14/24, C23C 14/56

(54) **Bedampfungseinrichtung zur Molekularstrahlbedampfung und Molekularstrahlepitaxie**
Vaporisation device for molecular beam vaporisation and molecular beam epitaxy
Dispositif de vaporisation destinés à la vaporisation par faisceaux moléculaire et épitaxie par faisceaux moléculaire

(30) Priorität: 14.03.2007 DE 102007012370
(43) Veröffentlichungstag der Anmeldung: 17.09.2008
(73) Patentinhaber: CreaTec Fischer & Co. GmbH, 74391 Erligheim (DE); Forschungsverbund Berlin E.V., 12489 Berlin (DE)
(72) Erfinder: Braun, Wolfgang, 13349 Berlin (DE); Fischer, Albrecht, 74369 Lochgau (DE)
(74) Vertreter: Beier, Ralph

(56) Entgegenhaltungen:
- WO-A-02/24984
- DE-A1- 19 852 326
- DE-A1-102004 041 846
- DE-C1- 4 422 697
- US-A- 2 440 135
- US-A- 5 906 857
- US-A1- 2005 034 672
- US-B1- 6 202 591

## Beschreibung

Die Erfindung betrifft eine Bedampfungseinrichtung zum Bedampfen eines Substrats mit einem Verdampfungsmaterial gemäß dem Hauptanspruch, insbesondere zur Molekularstrahlbedampfung (MBD: Molecular Beam Deposition) und zur Molekularstrahlepitaxie.

Aus DE 100 56 686 B4 ist eine Bedampfungseinrichtung bekannt, die zur Herstellung von Aufdampfschichten im Vakuum entsprechend dem Molekularstrahlepitaxie-Verfahren eingesetzt werden kann. Hierzu weist diese bekannte Bedampfungseinrichtung eine Effusionszelle mit einem beheizbaren Tiegel auf, in dem ein Verdampfungsmaterial erhitzt und verdampft wird. An seiner Oberseite weist der Tiegel eine kreisförmige Austrittsöffnung auf, durch die ein Molekülstrahl des Verdampfungsmaterials austritt und dann auf das zu beschichtende Substrat (z.B. einen Wafer) auftrifft. Darüber hinaus ist vor der Austrittsöffnung des Tiegels hierbei mittig eine scheibenförmige Abdeckblende angeordnet, die den Molekülstrahl mittig ausblendet und dadurch die normalerweise in der Mitte des Substrats überhöhte Schichtdicke herabsetzt, was zu einer Vergleichmäßigung der Schichtdicke auf dem Substrat führt.

Nachteilig an dieser bekannten Bedampfungseinrichtung ist jedoch die geringe Wirtschaftlichkeit bei der Bedampfung großer Substratflächen.

Aus DE 25 48 357 A1 und DE 44 22 697 C1 sind Bedampfungseinrichtungen bekannt, bei denen die Effusionszelle eine schlitzförmige Austrittsöffnung aufweist, die zur Bedampfung eines Substratbandes dient. Problematisch an diesen bekannten Bedampfungseinrichtungen ist jedoch das Nachfüllen der Effusionszelle, wozu der Bedampfungsbetrieb unterbrochen werden muss.

Aus DE 10 2004 041 846 A1 und DE 198 52 326 A1 sind Nachfüllvorrichtungen für Bedampfungseinrichtungen bekannt, die ein schnelles Nachfüllen der Effusionszelle ermöglichen. Hierbei ist die in der Nachfüllvorrichtung enthaltene Menge des Bedampfungsmaterials jedoch begrenzt, so dass die Nachfüllvorrichtung ihrerseits aufgefüllt werden muss, wenn die Menge des in der Nachfüllvorrichtung enthaltenen Bedampfungsmaterials erschöpft ist. Hierzu muss dann wiederum der normale Betrieb unterbrochen werden, was störend ist.

Schließlich ist aus US 2002/0197418 A1 eine fernerliegende Bedampfungseinrichtung bekannt.

Der Erfindung liegt deshalb die Aufgabe zugrunde, die vorstehend beschriebene bekannte Bedampfungseinrichtung zu verbessern.

Diese Aufgabe wird durch eine erfindungsgemäße Bedampfungseinrichtung gemäß dem Hauptanspruch gelöst.

Die Erfindung umfasst die allgemeine technische Lehre, dass das zu beschichtende Substrat relativ zu der Effusionszelle eine Vorschubbewegung ausführt, während der das Substrat von der Effusionszelle beschichtet wird.

Die Vorschubbewegung des Substrats relativ zu der Effusionszelle kann hierbei kontinuierlich erfolgen, so dass die Beschichtung des Substrats im bewegten Zustand erfolgt.

Es ist jedoch alternativ auch möglich, dass die Vorschubbewegung des zu beschichtenden Substrats taktweise erfolgt, wobei die Beschichtung des Substrats vorzugsweise in den Taktruhepausen erfolgt.

Weiterhin sieht die Erfindung vorzugsweise vor, dass es sich bei dem zu bedampfenden Substrat um ein Substratband mit einer bestimmten Bandbreite handelt, wobei die Effusionszelle das Substratband auf der gesamten Bandbreite mit dem Verdampfungsmaterial bedampft.

Die Erfindung eignet sich deshalb besonders gut zum Aufdampfen von CIS-Schichten (CIS: Copper-Indium-Selinide, CuInSe₂) und entsprechenden Materialkombinationen bei der Herstellung von Solarzellen.

In einem bevorzugten Ausführungsbeispiel der Erfindung weist die Austrittöffnung der Effusionszelle hierbei eine Aperturblende auf, die im Wesentlichen schlitzförmig ist und sich über die gesamte Bandbreite des Substratbands im Wesentlichen quer zu der Bandlängsrichtung erstreckt, so dass das Substratband auf der gesamten Bandbreite bedampft werden kann. Im Gegensatz zu der eingangs beschriebenen bekannten Effusionszelle gemäß DE 100 56 686 B4 deckt die Aperturblende den Molekülstrahl hierbei also vorzugsweise nur in einer Raumrichtung ab, nämlich in Bandlängsrichtung.

Weiterhin ist vorzugsweise vorgesehen, dass die Aperturblende der Effusionszelle eine Schlitzbreite aufweist, die sich über die Bandbreite so ändert, dass die Beschichtung auf der gesamten Bandbreite im Wesentlichen gleichmäßig erfolgt. Dies ist sinnvoll, weil die Schichtdicke bei einer schlitzförmigen Austrittsöffnung mit einer konstanten Schlitzbreite normalerweise in der Mitte des Substratbands überhöht ist und zu den Rändern des Substratbandes hin abnimmt. Der optimale Verlauf der Schlitzbreite der schlitzförmigen Aperturblende über die Bandbreite des zu beschichtenden Substratbands hängt hierbei von verschiedenen Faktoren ab, wie beispielsweise von der Vorschubgeschwindigkeit und der Bandbreite des Substratbands, der gewünschten Schichtdicke, der Wachstumsrate und dem Ausstoß der Effusionszelle. Vorzugsweise nimmt die Schlitzbreite jedoch von der Bandmitte ausgehend zu den Bandrändern hin zu, so dass die Aperturblende sanduhrförmig ist.

Bei der erfindungsgemäßen Bedampfungseinrichtung wird das Substratband durch eine Substratführung vor der Austrittsöffnung der Effusionszelle entlang geführt, wobei die Vorschubbewegung des Substratbandes vorzugsweise linear, unidirektional und parallel zu der Bandlängsrichtung des Substratbands bewegt.

Die Bandbreite des zu bedampfenden bandförmigen Substrat kann im Rahmen der Erfindung größer als 5cm, 10cm, 20cm, 30cm, 40cm oder sogar größer als 50cm sein. Die Erfindung ist jedoch hinsichtlich der Bandbreite des zu beschichtenden Substratbands nicht auf die vorstehend genannten Grenzwerte beschränkt, sondern grundsätzlich auch mit anderen Bandbreiten des Substratbands realisierbar.

Weiterhin ist zu erwähnen, dass die erfindungsgemäße Bedampfungseinrichtung vorzugsweise eine Vakuumkammer aufweist, in der die Effusionszelle angeordnet ist und in der auch die Bedampfung des Substratbands unter Vakuumbedingungen erfolgt, was an sich aus dem Stand der Technik bekannt ist und deshalb nicht näher beschrieben werden muss.

Gemäß der Erfindung weist die Bedampfungseinrichtung zusätzlich eine Nachfüllvorrichtung zum Nachfüllen der Effusionszelle mit dem Verdampfungsmaterial auf. Hierbei ist diese Nachfüllvorrichtung so ausgestaltet, dass das Verdampfungsmaterial im laufenden Betrieb der Bedampfungseinrichtung nachgefüllt werden kann, also unter Vakuumbedingungen, während das Substratband bedampft und bewegt wird. Das Nachfüllen des Verdampfungsmaterials im laufenden Betrieb verbessert ebenfalls die Wirtschaftlichkeit, da der Bedampfungsbetrieb nicht mehr zum Nachfüllen des Verdampfungsmaterials unterbrochen werden muss.

Das Nachfüllen des Verdampfungsmaterials kann hierbei wahlweise kontinuierlich oder diskontinuierlich erfolgen. Beim kontinuierlichen Nachfüllen des Bedampfungsmaterials wird im laufenden Betrieb der Bedampfungseinrichtung laufend ein kleiner Flüssigkeitsstrom des Verdampfungsmaterials in die Effusionszelle nachgefüllt. Beim diskontinuierlichen Nachfüllen des Verdampfungsmaterials weist die Effusionszelle dagegen einen kleinen Vorrat des Verdampfungsmaterials auf, so dass ein Nachfüllen erst erforderlich ist, wenn der Vorrat des Verdampfungsmaterials in der Effusionszelle aufgebraucht ist.

Gemäß der Erfindung weist die Nachfüllvorrichtung eine vakuumfeste Nachfüllkammer auf, die mit dem beheizbaren Tiegel in der Effusionszelle in Verbindung steht, so dass ein Vorrat des Verdampfungsmaterials aus der Nachfüllkammer in den Tiegel strömen kann. Während des laufenden Betriebs herrschen dann sowohl in dem Tiegel als auch in der Nachfüllkammer Vakuumbedingungen. Weiterhin weist die Nachfüllvorrichtung eine vakuumfeste Ladekammer auf, in die das nachzufüllende Verdampfungsmaterial über eine vakuumfeste und verschließbare Einfüllöffnung eingefüllt werden kann, wobei die Ladekammer von der Einfüllkammer durch eine vakuumfeste und verschließbare Trennluke getrennt ist. Zum Nachfüllen des Verdampfungsmaterials wird also zunächst die Einfüllöffnung der Ladekammer geöffnet, während die Trennluke zwischen der Ladekammer und der Nachfüllkammer geschlossen ist. Anschließend wird dann das nachzufüllende Verdampfungsmaterial in die Ladeluke eingeführt, woraufhin dann die Einfüllöffnung vakuumfest verschlossen wird. In einen nächsten Schritt wird dann die Ladekammer evakuiert, woraufhin die Trennluke zwischen der Nachfüllkammer und der Ladekammer geöffnet wird. Schließlich wird das nachzufüllende Verdampfungsmaterial dann aus der Ladekammer in die Nachfüllkammer überführt und dort als Vorrat deponiert. Die Ladekammer bildet hierbei also eine Vakuumschleuse, so dass die Vakuumbedingungen beim Nachfüllen des Verdampfungsmaterials aufrecht erhalten werden können.

Die Überführung des nachzufüllenden Verdampfungsmaterials aus der Ladekammer in die Nachfüllkammer erfolgt vorzugsweise durch eine Manipulationseinrichtung, die einen Behälter mit dem nachzufüllenden Verdampfungsmaterial aus der Ladekammer durch die geöffnete Trennluke in die Nachfüllkammer bringen kann.

In dem bevorzugten Ausführungsbeispiel weist diese Manipulationseinrichtung eine Transferstange auf, die an ihrem Ende einen Behälter mit dem nachzufüllenden Verdampfungsmaterial trägt, wobei die Transferstange beweglich ist. Zum einen kann die Transferstange in dem bevorzugten Ausführungsbeispiel der Erfindung entlang ihrer Längsachse verschoben werden, um den Behälter mit dem darin befindlichen Verdampfungsmaterial aus der Ladekammer durch die geöffnete Trennluke in die benachbarte Nachfüllkammer zu transferieren. Zum anderen ist die Transferstange in dem bevorzugten Ausführungsbeispiel der Erfindung um ihre Längsachse drehbar, um das in dem Behälter befindliche Verdampfungsmaterial in der Nachfüllkammer auszugießen.

Darüber hinaus ist in dem bevorzugten Ausführungsbeispiel der Erfindung vorgesehen, dass die Ladekammer der Nachfüllvorrichtung beheizbar ist. Dies bietet die Möglichkeit, dass das in die Ladekammer eingeführte Verdampfungsmaterial vor dem Transferieren in die Nachfüllkammer ausgeheizt und damit gereinigt wird.

Weiterhin ist zu erwähnen, dass die Ladekammer und die Nachfüllkammer der Nachfüllvorrichtung vorzugsweise jeweils separate Heizungen aufweisen, deren Heizleistung separat einstellbar sein kann.

Bei der erfindungsgemäßen Bedampfungseinrichtung kann der Tiegel der Effusionszelle aus verschiedenen Materialien bestehen, wie beispielsweise aus Quarz, Vanadium, pyrolytischem Bornitrid (PBN), Al2O3, Molybdän, Tantal oder einer Kombination dieser Materialien. Die Erfindung ist jedoch hinsichtlich der Materialien zur Herstellung des Tiegels nicht auf die vorstehend genannten Materialien beschränkt, sondern grundsätzlich auch mit anderen Materialien realisierbar.

In dem bevorzugten Ausführungsbeispiel der Erfindung weist die Effusionszelle eine Kühlung auf, die es ermöglicht, den Tiegel thermisch von seiner Umgebung zu isolieren. Beispielsweise kann es sich hierbei um eine Wasserkühlung handeln, die einen den Tiegel umgebenden Hohlmantel mit Kühlwasser durchströmt.

Darüber hinaus weist die Effusionszelle bei der erfindungsgemäßen Bedampfungseinrichtung vorzugsweise eine zusätzliche Abschirmung auf, die den Tiegel thermisch abschirmt.

Eine weitere Besonderheit der für die Erfindung nüblichen Effusionszelle besteht in dem bevorzugten Ausführungsbeispiel darin, dass eine geradlinige Verbindung von dem in dem Tiegel befindlichen Verdampfungsmaterial zu dem Substratband konstruktiv verhindert wird. Dadurch werden Tröpfchen, die beim Betrieb bei hohen Temperaturen gebildet werden, abgefangen und können wieder in den Tiegel zurücklaufen.

Beispielsweise kann dies durch Blenden erreicht werden, die in dem Tiegel vor der Austrittsöffnung angeordnet sind und jeweils einen Teilbereich des Öffnungsquerschnitts abdecken. Die Blenden bilden hierbei also in dem Tiegel vor der Austrittsöffnung eine Art Labyrinth und verhindern dadurch, dass Tröpfchen aus dem Tiegel geradlinig entweichen können.

Eine andere Alternative zur Verhinderung einer geradlinigen Verbindung zwischen dem in dem Tiegel befindlichen Verdampfungsmaterial und dem Substratband besteht in einer labyrinthartigen Gestaltung der Austrittsöffnung, die keine geradlinige Verbindung zulässt.

Weiterhin ist es vorteilhaft, wenn die Effusionszelle eine verstellbare Verschlussblende aufweist, um die Austrittsöffnung der Effusionszelle zu verschließen. Beispielsweise kann es sich bei der Verschlussblende um einen Verschlussschieber handeln, der zum Verschließen der Austrittsöffnung einfach über die Austrittsöffnung der Effusionszelle geschoben wird.

Es wurde bereits vorstehend erwähnt, dass der Tiegel der für die Erfindung nüblichen Effusionszelle beheizbar ist. In einer Variante der Erfindung ist die Heizleistung über die Breite des Substratbandes einstellbar, um das laterale Beschichtungsprofil im Betrieb dynamisch einstellen zu können. Beispielsweise können die Randbereiche des Tiegels stärker oder schwächer beheizt werden als der mittlere Bereich. Besonders vorteilhaft ist diese laterale Variation der Heizleistung dann, wenn eine Schichtdickenkontrolle erfolgt, welche die laterale Verteilung der Schichtdicke ermittelt. Die laterale Verteilung der Heizleistung kann dann von einer Regeleinheit in Abhängigkeit von der ermittelten lateralen Schichtdickenverteilung so geregelt werden, dass die gewünschte laterale Schichtdickenverteilung eingehalten wird.

Schließlich ist durch die Erfindung auch ein Substrat mit einer aufgedampften Beschichtung zugänglich, ein Substratband mit einer bestimmten Bandbreite, wobei sich die aufgedampfte Beschichtung über die gesamte Bandbreite des Substratbands erstreckt.

Eine weitere neue Eigenschaft des Substratbands besteht darin, dass die aufgedampfte Beschichtung über die gesamte Bandbreite eine im Wesentlichen konstante Schichtdecke aufweist. Dies bedeutet im Rahmen der Erfindung vorzugsweise, dass die Schwankung der Schichtdicke über die gesamte Bandbreite kleiner als 30%, 10%, 5% oder sogar kleiner als 2% ist.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher verdeutlicht. Es zeigen:
- Figur 1: eine Seitenansicht einer erfindungsgemäßen Bedampfungseinrichtung,
- Figur 2: eine Perspektivansicht der Bedampfungseinrichtung aus Figur 1 von einer Luftseite, auf der Normaldruck herrscht,
- Figur 3: eine Aufsicht auf die Bedampfungsanlage aus den Figuren 1 und 2,
- Figur 4: eine Perspektivansicht der Bedampfungseinrichtung aus den Figuren 1 bis 3 von einer Vakuumseite, auf der Vakuumbedingungen herrschen,
- Figur 5: eine Seitenansicht der Bedampfungseinrichtung aus den Figuren 1 bis 4 von der Vakuumseite,
- Figur 6: eine Seitenansicht der Bedampfungseinrichtung aus den Figuren 1 bis 5 von der Luftseite,
- Figur 7: eine Aufsicht auf die Bedampfungseinrichtung aus den Figuren 1 bis 6,
- Figur 8: eine Perspektivansicht der Effusionszelle der Bedampfungseinrichtung aus den Figuren 1 bis 7,
- Figur 9: eine teilweise aufgeschnittene Perspektivansicht der Effusionszelle aus Figur 8,
- Figur 10: eine Schnittansicht der Effusionszelle aus den Figuren 8 und 9,
- Figur 11: eine Aufsicht auf die Effusionszelle aus den Figuren 8 bis 10, sowie
- Figur 12: verschiedene mögliche Verläufe der Schlitzbreite der Aperturblende der Effusionszelle aus den Figuren 8 bis 11.

Die Zeichnungen zeigen eine erfindungsgemäße Bedampfungseinrichtung 1, die beispielsweise zur Erzeugung von CIS-Schichten (CIS: Copper-Indium-Selinide, CuInSe₂) bei der Herstellung von Solarzellen verwendet werden kann.

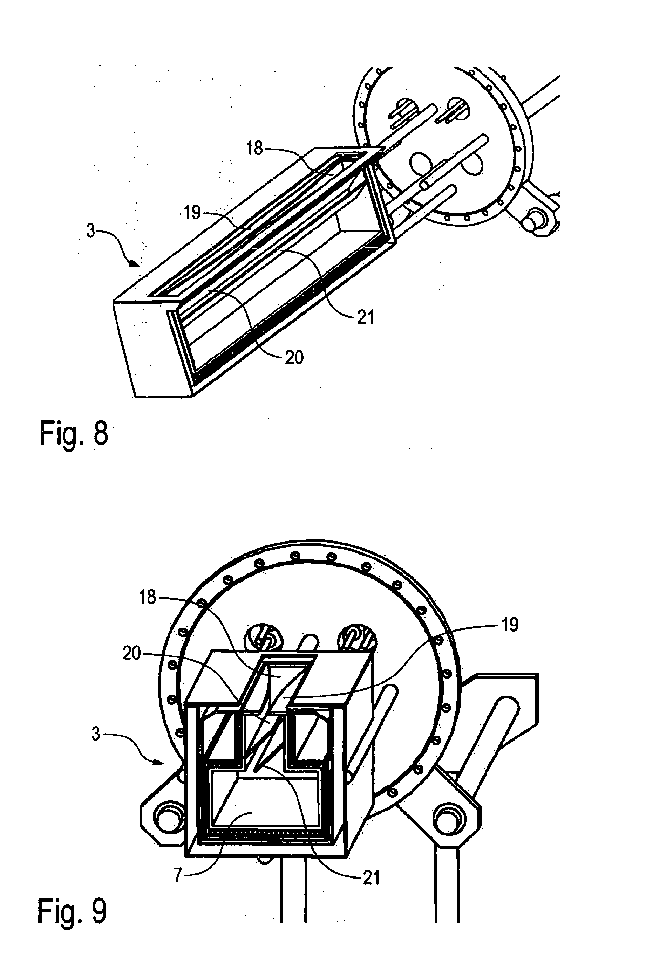

Die Bedampfungseinrichtung 1 weist zum Bedampfen eines Substratbands 2 eine Effusionszelle 3 auf, die in den Figuren 8 bis 9 detailliert dargestellt ist und noch eingehend beschrieben wird.

Das Substratband 2 weist in diesem Ausführungsbeispiel eine Bandbreite b=600mm auf, jedoch sind auch andere Bandbreiten des Substratbands 2 möglich.

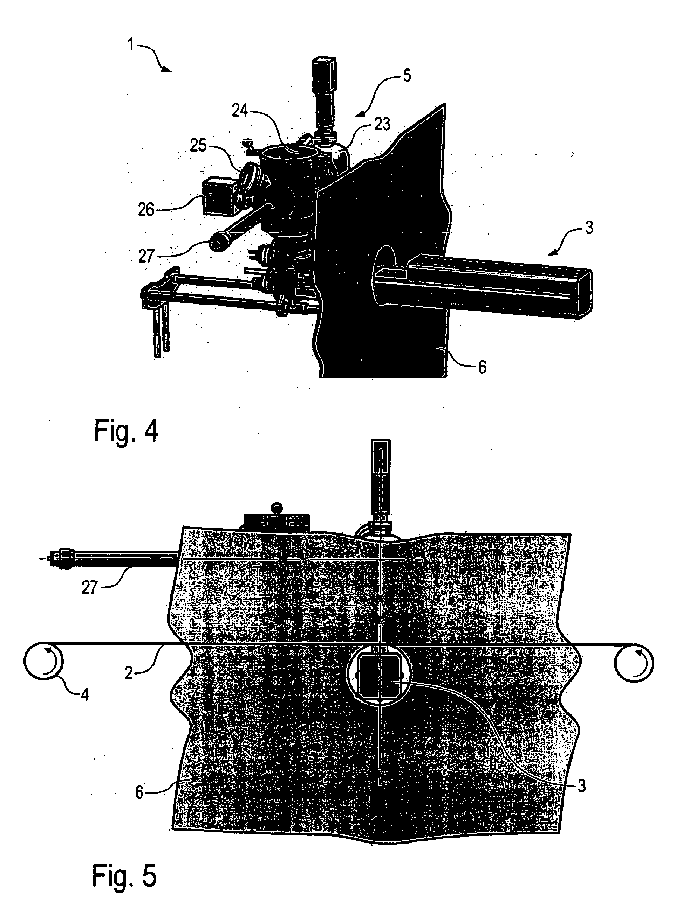

Weiterhin weist die Bedampfungseinrichtung 1 eine Substratführung 4 auf, die in Figur 5 in schematisierter Form dargestellt ist und das Substratband 2 im Betrieb mit einer bestimmten Vorschubgeschwindigkeit linear und unidirektional über die Effusionszelle 3 bewegt, wobei die Effusionszelle 3 die Unterseite des Substratbands 2 über die gesamte Bandbreite b mit einem Verdampfungsmaterial bedampft.

Darüber hinaus weist die erfindungsgemäße Bedampfungseinrichtung 1 in diesem Ausführungsbeispiel eine Nachfüllvorrichtung 5 auf, die es ermöglicht die Effusionszelle 3 im laufenden Betrieb mit dem Verdampfungsmaterial nachzufüllen, d.h. ohne eine Unterbrechung des Bedampfungsbetriebs.

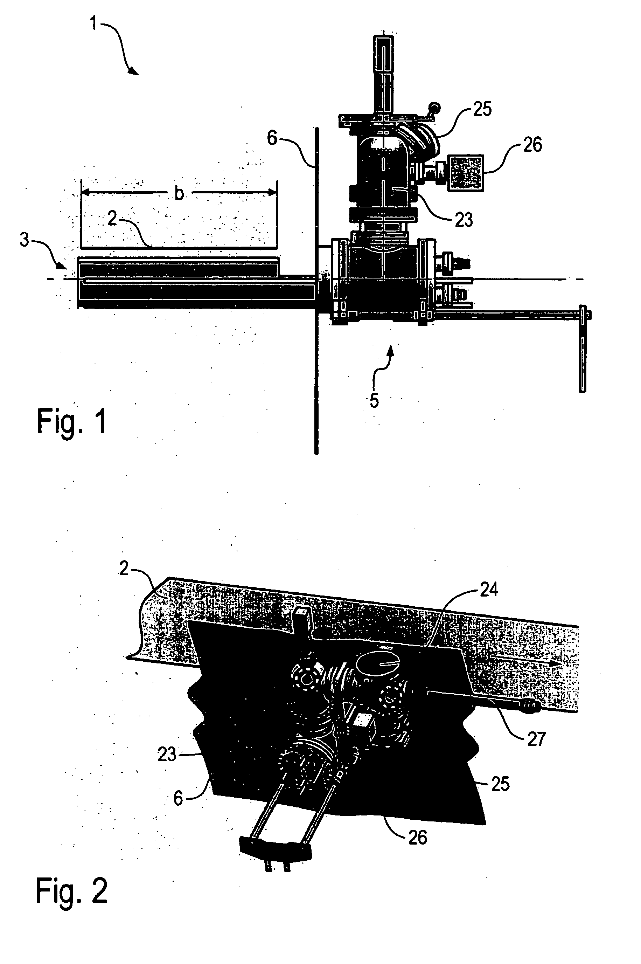

Die Beschichtung des Substratbands 2 durch die Effusionszelle 3 erfolgt hierbei innerhalb einer Vakuumkammer unter Vakuumbedingungen, wobei in den Zeichnungen nur eine Trennwand 6 der Vakuumkammer dargestellt ist. In der Darstellung gemäß Figur 1 herrschen also auf der linken Seite der Trennwand 6 im Betrieb Vakuumbedingungen, wohingegen auf der rechten Seite der Trennwand 6 atmosphärischer Druck herrscht.

Im Folgenden wird zunächst unter Bezugnahme auf die Figuren 8 bis 11 der konstruktive Aufbau und die Funktionsweise der Effusionszelle 3 beschrieben.

So weist die Effusionszelle 3 zur Aufnahme des Verdampfungsmaterials einen Tiegel 7 mit einem oben verjüngten Kaminbereich auf.

Der Tiegel 7 ist außen von insgesamt vier Heizwicklungen 8-11 umgeben, die im oberen Kaminbereich, am Übergang von dem Kaminbereich zu dem unteren Bereich des Tiegels 7, an den Seitenwänden des Tiegels 7 und am Boden des Tiegels 7 angeordnet sind und elektrisch unabhängig voneinander gesteuert werden können, um die Beheizung des Tiegels 7 zu steuern.

Die Heizwicklungen 8-11 können jeweils quer zu dem Substratband 2 in mehrere (z.B. drei) einzelne Heizungen getrennt sein, so dass beispielsweise der mittlere Bereich stärker oder schwächer geheizt werden kann als die Randbereiche, um das Beschichtungsprofil quer zu dem Substratband 2 dynamisch während der Beschichtung verändern zu können. Dies kann durch eine nachgeschaltete Schichtdickenkontrolle auch während der Beschichtung automatisch durch einen Regelkreis erfolgen.

An der Außenseite der Heizwicklungen 8-11 ist der Tiegel 7 von mehreren Abschirmungen 12-15 umgeben, die im oberen Kaminbereich, an dem horizontalen Übergang von dem Kaminbereich zu dem unteren Bereich des Tiegels 7, an den Seitenwänden des Tiegels 7 sowie am Boden des Tiegels 7 angeordnet sind und den Tiegel 7 thermisch abschirmen.

Die gesamte Effusionszelle 3 ist wiederum von einer gesamten Abschirmung 16 umgeben, welche den Tiegel 7 ebenfalls thermisch abschirmt.

An der Außenseite der Effusionszelle 3 befindet sich ferner ein Hohlmantel 17, der von einer Wasserkühlung mit Wasser als Kühlmittel durchströmt werden kann, um die Effusionszelle 3 zu kühlen.

In dem oberen Kaminbereich des Tiegels 7 befindet sich eine Austrittsöffnung 18, durch die ein Molekülstrahl des Verdampfungsmaterials austreten und das Substratband 2 beschichten kann. Die Austrittsöffnung 18 wird hierbei durch eine vorzugsweise beheizbare Aperturblende 19 begrenzt, die schlitzförmig ist und sich über die gesamte Bandbreite b des Substratbands 2 erstreckt, so dass der aus der Austrittsöffnung 18 austretende Molekülstrahl das Substratband 2 auf der gesamten Bandbreite b bedampfen kann.

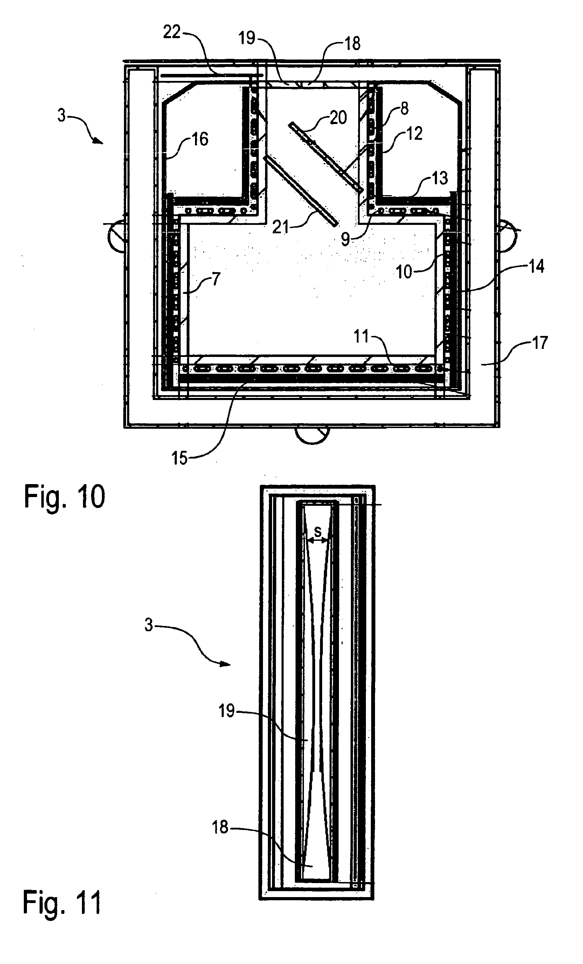

Aus der Aufsichtsdarstellung der Effusionszelle 3 in Figur 11 ist weiterhin ersichtlich, dass die Austrittsöffnung 18 eine Schlitzbreite s aufweist, die sich über die Bandbreite b des Substratbands 2 ändert, wobei die Schlitzbreite s vorzugsweise von der Mitte des Substratbands 2 ausgehend nach außen hin zunimmt, so dass die Austrittsöffnung 18 in der Aufsicht einen sanduhrförmigen Verlauf aufweist. Durch diese Formgebung der Austrittsöffnung 18 wird erreicht, dass die Beschichtung auf dem Substratband 2 über die gesamte Bandbreite b eine im Wesentlichen einheitliche Schichtdicke aufweist.

In dem oberen Kaminbereich des Tiegels 7 sind weiterhin zwei Blenden 20, 21 angeordnet, die eine gradlinige Verbindung von dem in dem Tiegel 7 befindlichen Verdampfungsmaterial zu dem Substratband 2 verhindern. Dadurch werden Tröpfchen des Verdampfungsmaterials, die beim Betrieb bei hohen Temperaturen gebildet werden, durch die labyrinthartigen Blenden 20, 21 abgefangen und können wieder in den Tiegel 7 zurücklaufen.

Ferner befindet sich an der Oberseite der Effusionszelle 3 eine Verschlussblende 22, die verschoben werden kann, um die Austrittsöffnung 18 des Tiegels 7 zu verschließen.

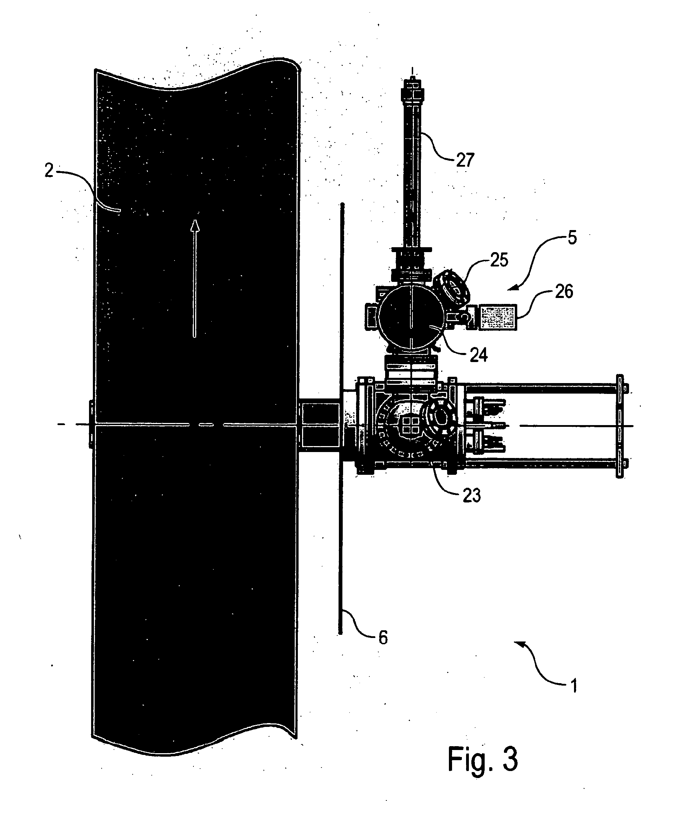

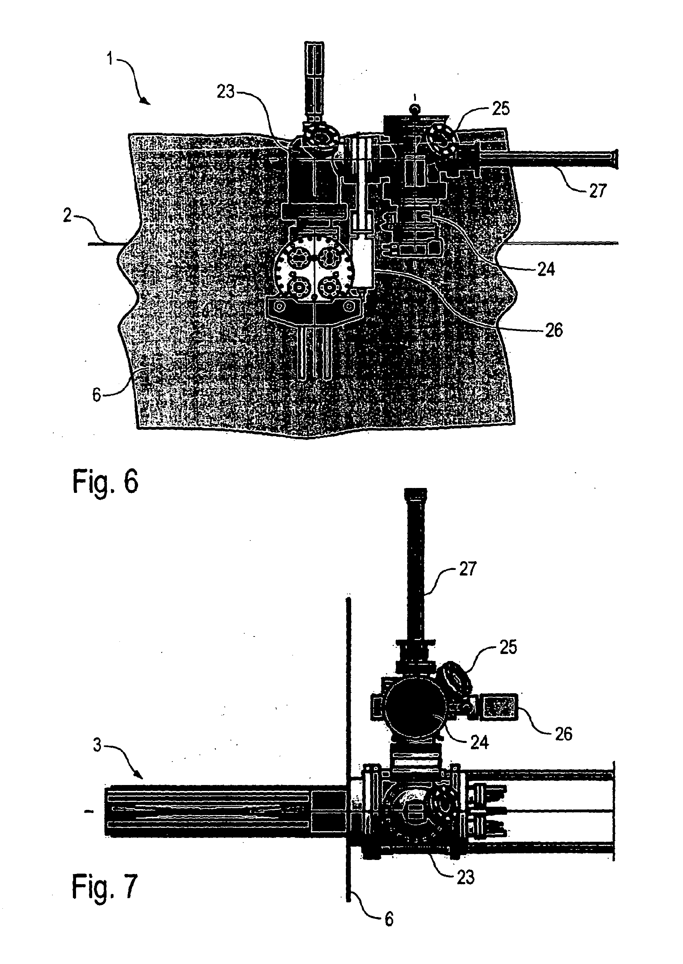

Im Folgenden wird nun unter Bezugnahme auf die Figuren 1 bis 7 die Nachfüllvorrichtung 5 der erfindungsgemäßen Bedampfungseinrichtung 1 beschrieben.

So weist die Nachfüllvorrichtung 5 eine vakuumfeste Nachfüllkammer 23 auf, in der ein Trichter angeordnet ist, von dem das eingefüllte Verdampfungsmaterial in den Tiegel 7 fließen kann.

Weiterhin weist die Nachfüllvorrichtung 5 eine vakuumfeste Ladekammer 24 mit einer verschließbaren Einführöffnung 25 auf, durch die das nachzufüllende Verdampfungsmaterial in die Ladekammer 24 eingeführt werden kann.

Die Ladekammer 24 ist hierbei über eine vakuumfeste und verschließbare Trennluke 26 (UHV-Schieberventil) mit der Nachfüllkammer 23 verbunden, so dass das nachzufüllende Verdampfungsmaterial aus der Ladekammer 24 in die Nachfüllkammer 23 überführt werden kann, wenn die Trennluke 26 geöffnet ist.

Zur Überführung des nachzufüllenden Verdampfungsmaterials aus der Ladekammer 24 in die Nachfüllkammer 23 ist eine Transferstange 27 vorgesehen, die an ihrem Ende einen Behälter für das nachzufüllende Verdampfungsmaterial trägt und entlang ihrer Längsachse verschiebbar und um ihre Längsachse drehbar ist.

Im Folgenden wird nun ein Nachfüllvorgang beschrieben.

Zu Beginn des Nachfüllvorgangs herrschen in der Nachfüllkammer 23 Vakuumbedingungen wie auf der Vakuumseite der Trennwand 6 in der Vakuumkammer, während in der Ladekammer 24 bei geschlossener Trennluke 26 atmosphärischer Druck herrscht.

Zum Nachfüllen des Verdampfungsmaterials wird dann zunächst die Einführöffnung 25 der Ladekammer 24 geöffnet und das nachzufüllende Verdampfungsmaterial in den Behälter gefüllt, der von der Transportstange 27 in der Ladekammer 24 gehalten wird.

Anschließend wird dann die Einführöffnung 25 der Ladekammer 24 vakuumfest verschlossen und ein Vakuum in der Ladekammer 24 erzeugt.

Nach dem Druckausgleich zwischen der Ladekammer 24 und der Nachfüllkammer 23 wird dann die Trennluke 26 geöffnet, so dass die Verbindung zwischen der Ladekammer 24 und der Nachfüllkammer 23 frei ist.

Die Transportstange 27 wird dann in Richtung der Nachfüllkammer 23 verschoben, bis sich der mit dem nachzufüllenden Verdampfungsmaterial gefüllte Behälter in der Nachfüllkammer 23 befindet.

Anschließend wird die Transferstange 27 dann um ihre Längsachse gedreht, wodurch das in dem Behälter befindliche Verdampfungsmaterial in den in der Nachfüllkammer 23 befindlichen Trichter gegossen wird.

Die Transferstange 27 wird dann wieder zurückgezogen und die Trennluke 26 zwischen der Nachfüllkammer 23 und der Ladekammer 24 wird am Ende des Nachfüllvorgangs wieder geschlossen.

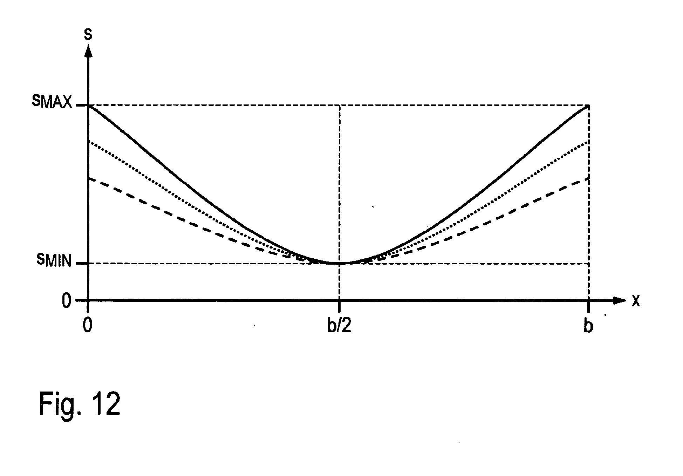

Schließlich zeigt Figur 12 verschiedene mögliche Verläufe der Schlitzbreite s der Aperturblende 19 über die Bandbreite b des Substratbands 2.

Daraus ist ersichtlich, dass die Schlitzbreite s der Aperturblende 19 in der Bandmitte x=b/2 einen Minimalwert s_{MIN} annimmt, während die Schlitzbreite s an den Bandrändern x=0 bzw. x=b einen Maximalwert s_{MAX} annimmt. Das Verhältnis des Maximalwerts s_{MAX} der Schlitzbreite s zu dem Minimalwert s_{MIN} der Schlitzbreite s kann beispielsweise im Bereich von 2...5 liegen, jedoch sind auch andere Werte möglich, was von den vorstehend genannten Einflussfaktoren abhängt.

Weiterhin ist aus dieser Darstellung ersichtlich, dass sich die Schlitzbreite s über die Bandbreite kontinuierlich ändert.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen.

### Bezugszeichenliste:

- 1: Bedampfungseinrichtung
- 2: Substratband
- 3: Effusionszelle
- 4: Substratführung
- 5: Nachfüllvorrichtung
- 6: Trennwand
- 7: Tiegel
- 8-11: Heizwicklungen
- 12-16: Abschirmungen
- 17: Hohlmantel
- 18: Austrittsöffnung
- 19: Aperturblende
- 20, 21: Blenden
- 22: Verschlussblende
- 23: Nachfüllkammer
- 24: Ladekammer
- 25: Einführöffnung
- 26: Trennluke
- 27: Transferstange

## Patentansprüche

1. Bedampfungseinrichtung (1) zum Bedampfen eines Substrats (2) mit einem Verdampfungsmaterial, wobei das zu bedampfende Substrat ein Substratband (2) ist, mit
a) einer Effusionszelle (3) mit einem Tiegel (7) zum Verdampfen des Verdampfungsmaterials, wobei die Effusionszelle (3) eine Austrittsöffnung (18) aufweist, um das Verdampfungsmaterial in einem verdampften Zustand auf das Substrat zu applizierenund mit
b) einer Substratführung (4), die das zu bedampfende Substrat vor der Austrittsöffnung (18) der Effusionszelle (3) positioniert und im Betrieb relativ zu der Austrittsöffnung (18) bewegt,
c) einer Nachfüllvorrichtung (5) zum Nachfüllen der Effusionszelle (3) mit dem Verdampfungsmaterial, wobei die Nachfüllvorrichtung (5) eine vakuumfeste Nachfüllkammer (23) aufweist, die mit dem Tiegel (7) in der Effusionszelle (3) in Verbindung steht, so dass ein Vorrat des Verdampfungsmaterials aus der Nachfüllkammer (23) in den Tiegel (7) strömen kann,
**dadurch gekennzeichnet,**
d) **dass** die Nachfüllvorrichtung (5) eine vakuumfeste Ladekammer (24) aufweist, in die das nachzufüllende Verdampfungsmaterial über eine vakuumfeste und verschließbare Einführöffnung (25) eingeführt werden kann, und
e) **dass** die Nachfüllkammer (23) durch eine vakuumfeste und verschließbare Trennluke (26) von der Ladekammer (24) getrennt ist.

2. Bedampfungseinrichtung nach Anspruch 1, **dadurch gekennzeichnet,**
a) **dass** das zu bedampfende Substrat ein Substratband (2) ist,
b) **dass** die Effusionszelle (3) das Substratband (2) auf der gesamten Bandbreite (b) mit dem Verdampfungsmaterial bedampft.

3. Bedampfungseinrichtung (1) nach einem der vorhergehenden Ansprüche, **dadurch gekennzeichnet, dass** die Austrittsöffnung (18) der Effusionszelle (3) eine Aperturblende (19) aufweist, die
a) schlitzförmig ist und/oder
b) sich über die gesamte Bandbreite (b) des Substratbands (2) erstreckt und/oder
c) rechtwinklig zu der Bandlängsrichtung ausgerichtet ist und/oder
d) eine Schlitzbreite (s) aufweist, die sich über die Bandbreite (b) so ändert, dass die Beschichtung auf der gesamten Bandbreite (b) gleichmäßig erfolgt, und/oder
e) eine Schlitzbreite (s) aufweist, die von der Bandmitte ausgehend zu den Bandrändern hin zunimmt.

4. Bedampfungseinrichtung (1) nach einem der vorhergehenden Ansprüche, **dadurch gekennzeichnet, dass** die Substratführung (4) das Substratband (2) vor der Austrittsöffnung (18) der Effusionszelle (3)
a) linear und/oder
b) unidirektional und/oder
c) parallel zu der Bandlängsrichtung des Substratbands (2) bewegt.

5. Bedampfungseinrichtung (1) nach einem der vorhergehenden Ansprüche, **dadurch gekennzeichnet, dass** die Bandbreite (b) des Substratbands (2) größer als 10cm, 20cm, 30cm, 40cm oder 50cm ist.

6. Bedampfungseinrichtung (1) nach einem der vorhergehenden Ansprüche, **gekennzeichnet durch** eine Vakuumkammer, in der die Effusionszelle (3) angeordnet ist und in der die Bedampfung des Substratbands (2) unter Vakuumbedingungen erfolgt.

7. Bedampfungseinrichtung (1) nach einem der vorhergehenden Ansprüche, **dadurch gekennzeichnet, dass** die Nachfüllvorrichtung (5) das Nachfüllen des Verdampfungsmaterials im laufenden Betrieb ermöglicht, also
a) unter Vakuumbedingungen und/oder
b) während der Bedampfung des Substratbands (2) und/oder
c) während der Bewegung des Substratband (2), und/oder
d) kontinuierlich oder
e) diskontinuierlich.

8. Bedampfungseinrichtung (1) nach einem der vorhergehenden Ansprüche, **dadurch gekennzeichnet, dass** die Nachfüllvorrichtung (5) eine Manipulationseinrichtung (27) aufweist, um einen Behälter mit dem nachzufüllenden Verdampfungsmaterial aus der Ladekammer (24) durch die geöffnete Trennluke (26) in die Nachfüllkammer (23) zu bringen.

9. Bedampfungseinrichtung (1) nach Anspruch 8,
**dadurch gekennzeichnet, dass**
a) dass die Manipulationseinrichtung eine Transferstange (27) aufweist, die den Behälter mit dem nachzufüllenden Verdampfungsmaterial trägt, und
b) dass die Transferstange (27) entlang ihrer Längsachse verschiebbar ist, um den Behälter mit dem nachzufüllenden Verdampfungsmaterial aus der Ladekammer (24) durch die geöffnete Trennluke (26) in die Nachfüllkammer (23) zu transferieren, und
c) dass die Transferstange (27) um ihre Längsachse drehbar ist, um den Behälter mit dem nachzufüllenden Verdampfungsmaterial in der Nachfüllkammer (23) auszugießen.

10. Bedampfungseinrichtung (1) nach einem der vorhergehenden Ansprüche, **dadurch gekennzeichnet, dass** die Nachfüllvorrichtung (5) zur Beheizung der Ladekammer (24) eine Heizung aufweist.

11. Bedampfungseinrichtung (1) nach einem der vorhergehenden Ansprüche, **dadurch gekennzeichnet, dass** die Effusionszelle (3) einen Tiegel (7) aufweist, in dem das Verdampfungsmaterial im Betrieb verdampft wird.

12. Bedampfungseinrichtung (1) nach Anspruch 11, **dadurch gekennzeichnet, dass** der Tiegel (7) aus einem der folgenden Materialien besteht:
a) Quarz,
b) Vanadium,
c) pyrolytisches Bornitrid,
d) A1203,
e) Molybdän,
f) Tantal,
g) einer Kombination der vorstehenden Materialien.

13. Bedampfungseinrichtung (1) nach einem der Ansprüche 11 bis 12, **dadurch gekennzeichnet, dass** die Effusionszelle (3) eine Heizung (8-11) aufweist, die den Tiegel (7) im Betrieb beheizt.

14. Bedampfungseinrichtung (1) nach einem der Ansprüche 11 bis 13, **dadurch gekennzeichnet, dass** die Effusionszelle (3) eine Kühlung (17) aufweist, die den Tiegel (7) im Betrieb kühlt oder thermisch von der Umgebung isoliert.

15. Bedampfungseinrichtung (1) nach Anspruch 14, **dadurch gekennzeichnet, dass** die Kühlung (17) eine Wasserkühlung ist, die einen den Tiegel (7) umgebenden Hohlmantel mit Kühlwasser durchströmt.

16. Bedampfungseinrichtung (1) nach einem der Ansprüche 11 bis 15, **dadurch gekennzeichnet, dass** die Effusionszelle (3) eine Abschirmung (12-16) aufweist, die den Tiegel (7) abschirmt.

17. Bedampfungseinrichtung (1) nach einem der Ansprüche 11 bis 16, **dadurch gekennzeichnet, dass** die Effusionszelle (3) eine geradlinige Verbindung von dem in dem Tiegel (7) befindlichen Verdampfungsmaterial zu dem Substratband (2) konstruktiv verhindert.

18. Bedampfungseinrichtung (1) nach Anspruch 17, **dadurch gekennzeichnet, dass** die Effusionszelle (3) mindestens eine Blende (20, 21) aufweist, die in dem Tiegel (7) zwischen dem zu verdampfenden Material und der Austrittsöffnung (18) angeordnet ist und eine geradlinige Verbindung von dem in dem Tiegel (7) befindlichen Verdampfungsmaterial zu dem Substratband (2) verhindert.

19. Bedampfungseinrichtung (1) nach einem der vorhergehenden Ansprüche, **dadurch gekennzeichnet, dass** die Effusionszelle (3) eine verstellbare Verschlussblende (22) aufweist, um die Austrittsöffnung (18) der Effusionszelle (3) zu verschließen.

## Claims

1. Vaporisation device (1) for vaporising a substrate (2) with an evaporation material,
wherein the substrate to be vaporised is a substrate band (2), with
a) an effusion cell (3) with a crucible (7) for vaporising the evaporation material, wherein the effusion cell (3) has an outlet (18) to apply the evaporation material to the substrate in a vaporised state, and with
b) a substrate guide (4), which positions the substrate to be vaporised in front of the outlet (18) of the effusion cell (3) and moves it relative to the outlet (18) during operation,
c) a replenishing device (5) for replenishing the effusion cell (3) with the evaporation material, wherein the replenishing device (5) has a vacuum-tight replenishing chamber (23), which connects to the crucible (7) in the effusion cell (3), so that a store of evaporation material can flow out of the replenishing chamber (23) into the crucible (7),
**characterised in that**
d) the replenishing device (5) has a vacuum-tight loading chamber (24), into which the evaporation material for replenishment can be introduced via a vacuum-tight and closable inlet (25), and
e) that the replenishing chamber (23) is separated from the loading chamber (24) by a vacuum-tight and closable separation hatch (26).

2. Vaporisation device according to claim 1, **characterised in that**
a) the substrate to be vaporised is a substrate band (2),
b) that the effusion cell (3) vaporises the substrate band (2) with the evaporation material on the entire width (b) of the band.

3. Vaporisation device (1) according to one of the preceding claims, **characterised in that** the outlet (18) of the effusion cell (3) has an aperture cover (19), which
a) is slit-shaped and/or
b) extends over the entire band width (b) of the substrate band (2) and/or
c) is oriented at right angles to the longitudinal direction of the band and/or
d) has a slit width (s), which changes over the band width (b) so that coating occurs evenly on the entire band width (b), and/or
e) has a slit width (s), which increases from the band centre towards the band edges.

4. Vaporisation device (1) according to one of the preceding claims, **characterised in that** the substrate guide (4) moves the substrate band (2)
a) linearly and/or
b) unidirectionally and/or
c) parallel to the band longitudinal direction of the substrate band (2) in front of the outlet (18) of the effusion cell (3).

5. Vaporisation device (1) according to one of the preceding claims, **characterised in that** the band width (b) of the substrate band (2) is larger than 10cm, 20cm, 30cm, 40cm or 50cm.

6. Vaporisation device (1) according to one of the preceding claims, **characterised by** a vacuum chamber, in which the effusion cell (3) is arranged and in which the vaporisation of the substrate band (2) occurs under vacuum conditions.

7. Vaporisation device (1) according to one of the preceding claims, **characterised in that** the replenishing device (5) allows the evaporation material to be replenished during routine operation, i.e.
a) under vacuum conditions and/or
b) during the vaporisation of the substrate band (2) and/or
c) during movement of the substrate band (2) and/or
d) continuously or
e) intermittently.

8. Vaporisation device (1) according to one of the preceding claims, **characterised in that** the replenishing device (5) has a manipulation device (27) to move a container with the evaporation material for replenishment from the loading chamber (24) through the open separation hatch (26) into the replenishing chamber (23).

9. Vaporisation device (1) according to claim 8, **characterised in that**
a) the manipulation device has a transfer bar (27), which carries the container with the evaporation material for replenishment, and
b) that the transfer bar (27) is displaceable along its longitudinal axis in order to transfer the container with the evaporation material for replenishment out of the loading chamber (24) through the open separation hatch (26) into the replenishing chamber (23), and
c) that the transfer bar (27) is rotatable around its longitudinal axis in order to empty the container with the evaporation material for replenishment in the replenishing chamber (23).

10. Vaporisation device (1) according to one of the preceding claims, **characterised in that** the replenishing device (5) has a heating means to heat the loading chamber (24).

11. Vaporisation device (1) according to one of the preceding claims, **characterised in that** the effusion cell (3) has a crucible (7), in which the evaporation material is vaporised during operation.

12. Vaporisation device (1) according to claim 11, **characterised in that** the crucible (7) is made from one of the following materials:
a) quartz,
b) vanadium,
c) pyrolytic boron nitride,
d) Al₂O₃,
e) molybdenum,
f) tantalum,
g) a combination of the above materials.

13. Vaporisation device (1) according to one of claims 11 to 12, **characterised in that** the effusion cell (3) has a heating means (8-11), which heats the crucible (7) during operation.

14. Vaporisation device (1) according to one of claims 11 to 13, **characterised in that** the effusion cell (3) has a cooling means (17), which cools the crucible (7) during operation or thermally insulates it from the surrounding area.

15. Vaporisation device (1) according to claim 14, **characterised in that** the cooling means (17) is a water cooling means, which passes cooling water through a hollow shell surrounding the crucible (7).

16. Vaporisation device (1) according to one of claims 11 to 15, **characterised in that** the effusion cell (3) has a shielding means (12-16), which shields the crucible (7).

17. Vaporisation device (1) according to one of claims 11 to 16, **characterised in that** the effusion cell (3) structurally prevents the evaporation material located in the crucible (7) from connecting rectilinearly with the substrate band (2).

18. Vaporisation device (1) according to claim 17, **characterised in that** the effusion cell (3) has at least one cover (20, 21), which is arranged in the crucible (7) between the material to be vaporised and the outlet (18) and prevents the evaporation material located in the crucible (7) from connecting rectilinearly with the substrate band (2).

19. Vaporisation device (1) according to one of the preceding claims, **characterised in that** the effusion cell (3) has an adjustable closure cover (22) to close the outlet (18) of the effusion cell (3).

## Revendications

1. Dispositif de vaporisation (1) destiné à la vaporisation d'un substrat (2) avec un matériau de vaporisation, ledit substrat à vaporiser étant une bande de substrat (2), comprenant
a) une cellule à effusion (3) pour la vaporisation du matériau de vaporisation, ladite cellule à effusion (3) comportant une ouverture de sortie (18) permettant l'application sur le substrat du matériau de vaporisation en état de vaporisation, et
b) un guidage de substrat (4), lequel positionne le substrat à vaporiser devant l'ouverture de sortie (18) de la cellule à effusion (3) et, en état de fonctionnement, déplace celui-ci relativement à l'ouverture de sortie (18),
c) un système de remplissage (5) pour le remplissage de la cellule à effusion (3) avec le matériau de vaporisation, ledit système de remplissage (5) comportant un compartiment de remplissage (23) étanche au vide relié au creuset (7) de la cellule à effusion (3), si bien qu'une réserve du matériau de vaporisation peut s'écouler du compartiment de remplissage (23) dans le creuset (7),
**caractérisé**
d) **en ce que** le système de remplissage (5) comporte un compartiment de charge (24) étanche au vide où le matériau de vaporisation à déverser peut être conduit par une ouverture de remplissage (25) étanche au vide et obturable, et
e) **en ce que** le compartiment de remplissage (23) est séparé du compartiment de charge (24) par une fenêtre de séparation (26) étanche au vide et obturable.

2. Dispositif de vaporisation selon la revendication 1, **caractérisé**
a) **en ce que** le substrat à vaporiser est une bande de substrat (2),
b) **en ce que** la cellule à effusion (3) applique le matériau de vaporisation sur toute la largeur (b) de la bande de substrat (2).

3. Dispositif de vaporisation (1) selon l'une des revendications précédentes, **caractérisé en ce que** l'ouverture de sortie (18) de la cellule à effusion (3) comporte un diaphragme d'ouverture (19), lequel
a) est en forme de fente et/ou
b) s'étend sur toute la largeur (b) de la bande de substrat (2) et/ou
c) est orienté perpendiculairement à la direction longitudinale de la bande et/ou
d) présente une largeur de fente (s) variant sur la largeur de bande (b) de manière à permettre un revêtement homogène sur toute la largeur de bande (b), et/ou
e) présente une largeur de fente (s) augmentant à partir du milieu de la bande jusqu'aux bords de la bande.

4. Dispositif de vaporisation (1) selon l'une des revendications précédentes, **caractérisé en ce que** le guidage de substrat (4) déplace la bande de substrat (2) devant l'ouverture de sortie (18) de la cellule à effusion (3),
a) linéairement et/ou
b) unidirectionnellement et/ou
c) parallèlement à la direction longitudinale de la bande de substrat (2).

5. Dispositif de vaporisation (1) selon l'une des revendications précédentes, **caractérisé en ce que** la largeur (b) de la bande de substrat (2) est supérieure à 10 cm, 20 cm, 30 cm, 40 cm ou 50 cm.

6. Dispositif de vaporisation (1) selon l'une des revendications précédentes, **caractérisé par** une chambre à vide où est disposée la cellule à effusion (3) et où est effectuée la vaporisation de la bande de substrat (2) dans des conditions de vide.

7. Dispositif de vaporisation (1) selon l'une des revendications précédentes, **caractérisé en ce que** le système de remplissage (5) permet le déversement du matériau de vaporisation en cours de fonctionnement, soit
a) dans des conditions de vide et/ou
b) pendant la vaporisation de la bande de substrat (2) et/ou
c) pendant le déplacement de la bande de substrat (2), et/ou
d) de manière continue ou
e) de manière discontinue.

8. Dispositif de vaporisation (1) selon l'une des revendications précédentes, **caractérisé en ce que** le système de remplissage (5) comprend un dispositif de manipulation (27) pour amener un récipient contenant le matériau de vaporisation à déverser, du compartiment de charge (24) au compartiment de remplissage (23) en passant par la fenêtre de séparation (26) ouverte.

9. Dispositif de vaporisation (1) selon la revendication 8,
**caractérisé**
a) **en ce que** le dispositif de manipulation comprend une tringle de transfert (27) supportant le récipient contenant le matériau de vaporisation à déverser, et
b) **en ce que** ladite tringle de transfert (27) est déplaçable le long de son axe longitudinal pour transférer le récipient contenant le matériau de vaporisation à déverser, du compartiment de charge (24) au compartiment de remplissage (23) en passant par la fenêtre de séparation (26) ouverte, et
c) **en ce que** ladite tringle de transfert (27) est rotative autour de son axe longitudinal, pour déverser le contenu du récipient de matériau de vaporisation à déverser dans le compartiment de remplissage (23).

10. Dispositif de vaporisation (1) selon l'une des revendications précédentes, **caractérisé en ce que** le système de remplissage (5) comprend un chauffage destiné à chauffer le compartiment de charge (24).

11. Dispositif de vaporisation (1) selon l'une des revendications précédentes, **caractérisé en ce que** la cellule à effusion (3) comprend un creuset (7) dans lequel le matériau de vaporisation est vaporisé en état de fonctionnement.

12. Dispositif de vaporisation (1) selon la revendication 11, **caractérisé en ce que** le creuset (7) est constitué d'un des matériaux suivants :
a) quartz,
b) vanadium,
c) nitrure de bore pyrolytique,
d) Al2O3,
e) molybdène,
f) tantale,
g) une combinaison des précédents matériaux.

13. Dispositif de vaporisation (1) selon l'une des revendications 11 ou 12, **caractérisé en ce que** la cellule à effusion (3) comprend un chauffage (8-11), lequel chauffe le creuset (7) en état de fonctionnement.

14. Dispositif de vaporisation (1) selon l'une des revendications 11 à 13, **caractérisé en ce que** la cellule à effusion (3) comprend un refroidissement (17) qui refroidit le creuset (7) en état de fonctionnement ou isole thermiquement celui-ci de son environnement.

15. Dispositif de vaporisation (1) selon la revendication 14, **caractérisé en ce que** le refroidissement (17) est un refroidissement à eau, dont l'eau de refroidissement circule au travers d'une enveloppe creuse entourant le creuset (7).

16. Dispositif de vaporisation (1) selon l'une des revendications 11 à 15, **caractérisé en ce que** la cellule à effusion (3) comprend un blindage (12-16) qui protège le creuset (7).

17. Dispositif de vaporisation (1) selon l'une des revendications 11 à 16, **caractérisé en ce que** la cellule à effusion (3) empêche par sa construction une liaison en ligne droite entre le matériau de vaporisation qui se trouve dans le creuset (7) et la bande de substrat (2).

18. Dispositif de vaporisation (1) selon la revendication 17, **caractérisé en ce que** la cellule à effusion (3) comprend au moins un diaphragme (20, 21) disposé dans le creuset (7) entre le matériau à vaporiser et l'ouverture de sortie (18) et empêchant une liaison en ligne droite entre le matériau de vaporisation qui se trouve dans le creuset (7) et la bande de substrat (2).

19. Dispositif de vaporisation (1) selon l'une des revendications précédentes, **caractérisé en ce que** la cellule à effusion (3) comprend un diaphragme d'obturation (22) déplaçable pour obturer l'ouverture de sortie (18) de la cellule à effusion (3).
